(19) Europäisches Patentamt
European Patent Office
Office européen des brevets

(11) **EP 3 155 662 B1**

(12) **FASCICULE DE BREVET EUROPEEN**

(45) Date de publication et mention
de la délivrance du brevet:
**23.10.2019 Bulletin 2019/43**

(21) Numéro de dépôt: **15729435.6**

(22) Date de dépôt: **12.06.2015**

(51) Int Cl.:
*H01L 27/146* *(2006.01)*

(86) Numéro de dépôt international:
**PCT/EP2015/063112**

(87) Numéro de publication internationale:
**WO 2015/189359 (17.12.2015 Gazette 2015/50)**

(54) **STRUCTURE DE CIRCUIT DE LECTURE À INJECTION DE CHARGE**

STRUKTUR EINER AUSLESESCHALTUNG MIT LADUNGSINJEKTION

STRUCTURE OF A READOUT CIRCUIT WITH CHARGE INJECTION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.06.2014 FR 1455361**

(43) Date de publication de la demande:
**19.04.2017 Bulletin 2017/16**

(73) Titulaire: **New Imaging Technologies
91370 Verrières-le-Buisson (FR)**

(72) Inventeur: **NI, Yang
F-91120 Palaiseau (FR)**

(74) Mandataire: **Regimbeau
87 rue de Sèze
69477 Lyon Cedex 06 (FR)**

(56) Documents cités:
**EP-A1- 0 434 502          US-A1- 2007 285 545
US-A1- 2012 085 888**

**Description**

DOMAINE DE L'INVENTION

L'invention concerne une structure de circuit de lecture pour un capteur électromagnétique.

Par « capteur électromagnétique » on entend dans ce texte un capteur de rayonnement électromagnétique composé de circuits de lecture de pixels, chaque pixel comprenant au moins une photodiode pour émettre un signal électrique représentatif du rayonnement auquel le pixel est exposé. Un tel capteur est réalisé à partir d'un substrat semi-conducteur (par exemple en silicium) dans lequel les photodiodes sont constituées. Le rayonnement que l'on cherche à exploiter peut par exemple être un rayonnement dans le spectre visible, toutefois ceci n'est pas limitatif.

Le signal électrique émis par chaque photodiode est lu par un circuit de lecture (généralement un circuit de lecture respectif est dédié à chaque photodiode à cette fin). Les circuits de lecture sont également constitués dans le substrat semi-conducteur silicium.

L'invention trouve une application avantageuse dans les capteurs hybrides.

Un capteur est dit « hybride » lorsque les photodiodes sont constituées dans un premier substrat distinct d'un second substrat qui intègre les circuits de lecture et dont le matériau semi-conducteur peut différer du matériau du premier substrat.

Ceci est le cas notamment lorsque les circuits de lecture sont constitués dans un substrat en silicium (ce qui correspond à la configuration la plus courante pour ces circuits de lecture), alors que les photodiodes sont souvent constituées dans un substrat dans un autre matériau, par exemple l'arséniure de gallium-indium (In-GaAs), qui permet de constituer des photodiodes sensibles à des longueurs d'onde adaptées à la vision de nuit, auxquelles une photodiode dans un substrat silicium n'est pas sensible.

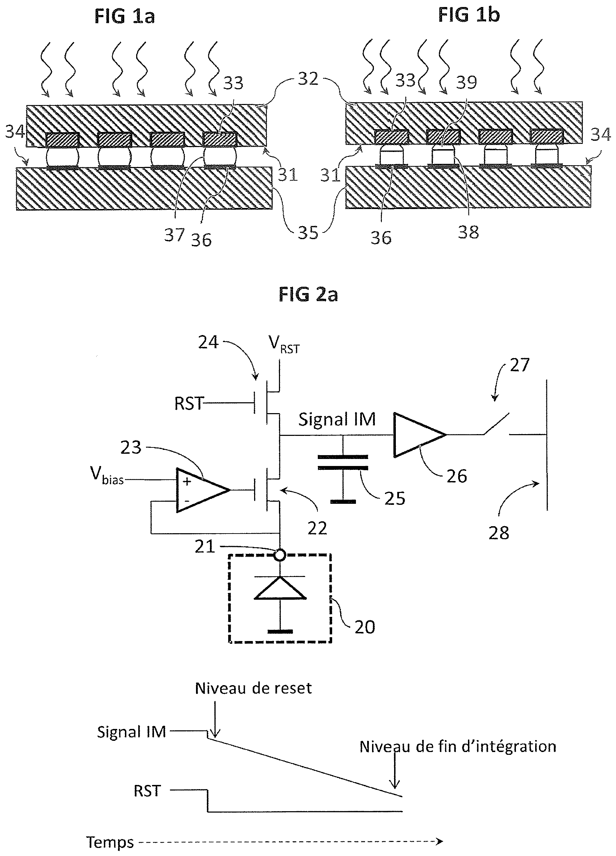

Dans le cas d'un capteur hybride chaque photodiode du premier substrat est connectée à un circuit de lecture du deuxième substrat par une liaison de type soudure, par exemple en bille en indium. Les figures 1a et 1b montrent des exemples de configurations possibles de cette hybridation, selon la technique de puce retournée (« flip chip » en anglais). Selon cette technique, la face 31 du premier substrat 32 au niveau de laquelle sont réalisées les photodiodes 33, et la face 34 du deuxième substrat 35 au niveau de laquelle est réalisé le circuit de lecture 36, se font face. Dans un premier exemple illustré par la figure 1a, chacune des photodiodes 33 du premier substrat 32 est relié au circuit de lecture 36 par une bille en indium 37, tandis que dans le second exemple illustré par la figure 1b, la liaison est réalisée par un pilier 38 en cuivre partant du deuxième substrat 35 et par une soudure 39 entre ce pilier 38 et la photodiode 33.

CONTEXTE DE L'INVENTION

La lecture des signaux issus des photodiodes est réalisée à une fréquence donnée, qui est généralement la même fréquence pour toutes les photodiodes. Par exemple pour des applications vidéo la fréquence peut être de 50 ou de 60 Hertz. Pour des applications d'acquisition rapide ou ultra-rapide, la fréquence est supérieure.

La lecture des photodiodes se fait ainsi par « cycles », chaque cycle correspondant au temps d'intégration du pixel, c'est-à-dire au temps pendant lequel la charge électrique (constituée par les charges des électrons ou trous, selon la nature de la photodiode) générée par la photodiode est accumulée soit dans la photodiode soit dans le circuit de lecture, ainsi qu'au temps de lecture du pixel.

Le circuit de lecture de la photodiode peut être réalisé de différentes manières, dans une technologie CMOS. Il peut être notamment de type "injection directe" (DI pour Direct Injection en anglais), "amplification capacitive à trans-impédance" (CTIA pour "Capacitive Trans-Impedance Amplifier" en anglais), ou "suiveur de source par pixel" (SFP pour "Source Follower per Pixel" en anglais). Ces trois types de circuits de lecture sont illustrés sur les figures 2a à 2c.

La figure 2a illustre un exemple de schéma électrique d'un circuit de lecture de pixel de type injection directe dans une configuration hybride. Un amplificateur 23 associé à un transistor 22 stabilise la tension de polarisation appliquée à la photodiode 20 via le contact d'hybridation 21 entre le premier substrat sur lequel est réalisée la photodiode 20 et le second substrat sur lequel est réalisé le circuit de lecture. Un transistor d'initialisation 24 est commandé par un signal d'initialisation RST pour appliquer en sortie du transistor 22 une tension d'initialisation $V_{RST}$. Un condensateur d'intégration 25 est adapté pour intégrer le photo-courant émis par la photodiode 20. Un amplificateur tampon 26 permet d'envoyer la tension Signal IM aux bornes de ce condensateur d'intégration 25 vers un bus de multiplexage de balayage 28, via un commutateur de sélection 27.

Un cycle de lecture comprend :

1) l'initialisation du condensateur d'intégration 25 au moyen du transistor d'initialisation 24,
2) intégration dans le condensateur 25 des charges photoélectriques générées par ladite photodiode 20,
3) lecture de la tension Signal IM aux bornes du condensateur 25 via la commande du commutateur 27.

Le résultat de la lecture peut soit être sorti directement du circuit de lecture pour être exploité, soit être stocké dans une mémoire présente dans chaque pixel pour être exploité ultérieurement.

La réinitialisation du condensateur d'intégration 25 et de la photodiode 20 produit cependant un bruit électronique dit "KTC", K désignant la constante de Boltzmann, T la température en Kelvin et C la capacité du condensateur d'intégration 25, en référence aux grandeurs influençant ce bruit. Après l'initialisation, la charge résiduelle dans le condensateur d'intégration 25 présente une variation aléatoire dont la moyenne quadratique vaut $\sqrt{KTC}$.

Ainsi, ce bruit KTC se traduit par une erreur de déviation de la tension aux bornes du condensateur d'intégration 25 par rapport à la tension de reset $V_{RST}$.

Afin de supprimer ce bruit de commutation, il a été développé une stratégie combinant deux lectures de tension en sortie du pixel : il s'agit donc d'une double lecture corrélée, également connue sous sigle CDS (pour « Correlated Double Sampling »).

Une première lecture est réalisée en début de cycle, immédiatement après que le condensateur a été remis dans un état initial (réinitialisation ou 'reset' en anglais - terme que l'on utilisera parfois par commodité et qui doit être considéré comme équivalent), par une mise à un potentiel de référence. Cette première lecture donne une première valeur lue de la quantité de charges initiale dans le condensateur.

La deuxième lecture est réalisée en fin de cycle, lorsque le condensateur est chargé et qu'on désire lire la valeur du cumul des charges intégrées.

Une fois les deux lectures effectuées et le cycle se terminant, des moyens de comparaison et de calcul établissent la différence entre les deux valeurs lues. Cette différence donne la quantité de charges générées par la photodiode qui a été intégrée par le condensateur pendant la durée d'intégration.

Ces circuits et méthodes de types connus permettent ainsi de déterminer, par calcul de la différence entre une lecture de début de cycle et une lecture de fin de cycle, pour chaque photodiode et pour chaque cycle, une valeur de la quantité de charges intégrées dans le condensateur en provenance de la photodiode pendant le cycle d'intégration.

Cependant d'autres sources de bruit existent dans un circuit de lecture de photodiode. Or, pour la plupart de ces bruits, il n'y a pas corrélation entre la première lecture et la seconde lecture. Ainsi, non seulement ces autres bruits ne sont pas supprimés, mais en plus leur densité spectrale de puissance est majorée d'un facteur 2.

Pour un circuit de lecture CMOS (de l'anglais Complementary Metal Oxide Semiconductor) un bruit électronique dit 1/f est le bruit dominant dans tous les composants actifs tels que les transistors. La densité spectrale de puissance de ce bruit en 1/f décroît avec la fréquence. Ainsi, à basse fréquence, le bruit 1/f est important. Or, la fréquence des cycles de fonctionnement du pixel est de l'ordre de 50 Hz, ce qui se traduit par un bruit 1/f important qui limite l'efficacité de la double-lecture corrélée.

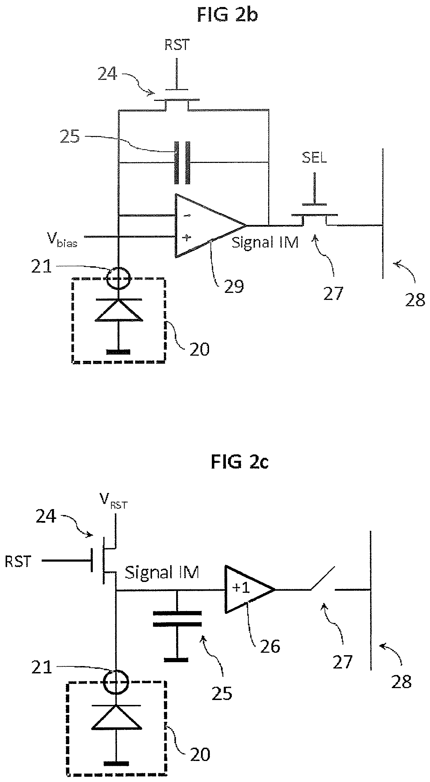

Afin de réduire le bruit 1/f par rapport à l'injection directe, un autre type de circuit dit CTIA, de l'anglais « Capacitive Trans-impedance Amplifier » pour amplificateur à trans-impédance capacitif, dont un exemple schématique est illustré par la figure 2b.

Le principe est similaire à celui d'un circuit à injection directe, avec des éléments similaires désignés par les mêmes références numériques. Le photo-courant issu de la photodiode 20 est intégré dans le condensateur 25 à travers un amplicateur opérationnel 29 muni d'une contre-réaction capacitive. L'initialisation se fait en vidant les charges dans le condensateur 25 au moyen du transistor d'initialisation 24 connecté en parallèle. La tension de polarisation de la photodiode 20 est maintenue grâce au fort gain de l'amplificateur opérationnel 29.

Le principe de base de cette configuration est que la contre-réaction capacitive atténue le bruit de basse fréquence et que l'efficacité de la double lecture corrélée en est ainsi améliorée. La séquence de lecture est la même que celle d'un pixel à injection directe : une première lecture est faite après la réinitialisation et une seconde lecture est faite après le temps d'intégration, le signal d'image étant constitué par la différence entre ces deux lectures.

Malgré la complexité du pixel, le bruit 1/f reste important. En effet, les meilleurs circuits de lecture CTIA ne peuvent pas descendre en deçà d'un niveau de bruit correspondant à la charge de 40 à 50 électrons, pour une valeur de capacité très faible (5 à 10 fF). Dans une telle configuration, la dynamique du circuit est très faible, et il sature facilement lorsque l'exposition lumineuse devient trop importante.

Une autre configuration dite SFP, pour l'anglais « Source Follower per Pixel », suiveur de source par pixel, dont la figure 2c montre un exemple de mode de réalisation. Cette configuration vise à réduire le nombre de transistors afin de diminuer le nombre de sources de bruit 1/f.

Le cycle de fonctionnement est le même qu'un circuit de lecture de pixel Di ou CTIA, et les éléments similaires à ces circuits sont désignés par les mêmes références numériques. Dans un circuit de lecture de pixel SFP, l'intégration du photo-courant issu de la photodiode 20 est réalisée directement sur le condensateur d'intégration 25 de la photodiode, y compris quelques capacités parasites. La forte valeur capacitive de la photodiode 20 réduit l'amplitude du signal lu en tension. Le bruit du circuit de lecture limite finalement le niveau de bruit rapporté à la photodiode 20 en nombre d'électrons. Par exemple, un circuit de lecture de pixel CTIA peut fonctionner avec une capacité de 5 fF pour le condensateur d'intégration, et pour un bruit de lecture d'une amplitude de 320 µV, le niveau de bruit est ainsi équivalent à la charge électrique de 10 électrons. Dans un circuit de lecture de pixel SFP, la capacité d'intégration peut difficilement être inférieure à 20 fF. Dans ce cas, le bruit de lecture de 320 µV se traduit par un bruit équivalent à 40 électrons.

Un autre inconvénient pour la double lecture corrélée dans chacun de ces circuits est que la première lecture prend place au début du cycle d'intégration, tandis que la seconde lecture prend place à la fin de celuici. Les deux lectures sont donc séparées par un temps assez long, comparable au temps du cycle. Le temps séparant les deux lectures de chaque cycle correspond en effet au temps d'intégration, qui est égal au temps de cycle (au temps de reset près). Or entre ces deux lectures d'autres bruits électroniques que le bruit KTC peuvent perturber la mesure, comme le bruit 1/f, qui peut ainsi, par ses variations entre les deux lectures, conduire à des valeurs de charges (déduites de la différence des deux valeurs lues) erronées. Ceci est pénalisant et le sera d'autant plus que le temps de cycle est long, correspondant à des fréquences faibles. A titre d'illustration une application particulièrement pénalisée par cette limitation est la vision à bas niveau de lumière, qui exige des temps de cycle longs, avec des fréquences de l'ordre de 50 Hz.

Une autre limitation de ces circuits et méthodes connus est qu'ils nécessitent de mémoriser dans une mémoire la valeur lue en début de cycle, pour ensuite effectuer l'opération de comparaison et de soustraction en fin de cycle. Par conséquent, une mémoire, par exemple externe ou au contraire dans chaque circuit de lecture de pixel, est donc nécessaire pour stocker la première lecture pendant la durée d'intégration.

La demande US 2007/0285545 présente un pixel actif dans lequel une photodiode est reliée à un nœud de collecte de charge d'un pixel actif, maintenu à une tension constante et formant le drain d'un transistor à polarisation constante, de sorte que les charges sont transférées à un nœud d'intégration de charge. Cette configuration nécessite cependant un transistor dédié, et ne permet pas de dépléter correctement la région d'intégration, dégradant ainsi la détection ultérieure des charges.

PRESENTATION DE L'INVENTION

L'invention vise à permettre de s'affranchir de ces limitations et inconvénients. A cet effet, il est proposé une structure de circuit de lecture comme définie dans la revendication 1.

La structure est avantageusement complétée par les caractéristiques suivantes, prises seules ou en quelconque de leurs combinaisons techniquement possibles:

- la structure de récupération de charges comprend un nœud de diffusion flottant formé par une région dopée du second type dans le substrat, connectée à un dispositif de sortie ;
- les moyens pour initialiser la structure de récupération de charges comprennent un transistor d'initialisation dont la grille, électriquement isolée du substrat, est située entre ledit nœud de diffusion et une source de potentiel de référence, et est adaptée pour être commandée pour amener le potentiel dudit nœud de diffusion audit potentiel initial ;

- la structure comprend un transistor de transfert de type MOS dont la grille de transfert est située entre ladite diode enterrée et ledit nœud de diffusion flottant, au-dessus et électriquement isolée du substrat, et qui est commandable pour transférer les charges collectées dans la seconde région dopée vers le nœud de diffusion flottant ;
- la structure de récupération de charges comprend

  • une mémoire constituée par une région dopée du second type et
  • un nœud de diffusion flottant formé par une région dopée du second type connectée à un dispositif de sortie,

  ladite mémoire étant formée dans le substrat entre la diode enterrée et le nœud de diffusion flottant ;
- un dispositif de sortie est branché entre la source de charge extérieure (une photodiode extérieure) et la diode d'injection afin de permettre une lecture de la tension aux bornes de la diode d'injection et obtenir ainsi une lecture logarithmique du courant passant entre source de charge extérieure et la diode d'injection ;
- la structure comprend une zone de confinement formée par une région dopée du premier type formée dans le substrat, ladite zone de confinement s'étendant dans la profondeur du substrat au moins en regard de la première région dopée composant la diode d'injection ;
- la zone de confinement s'étend en outre en direction de la surface du substrat jusqu'à la périphérie de la diode d'injection ;
- la structure comprend une région dopée du premier type formée dans le substrat qui entoure une région dopée du second type des moyens d'initialisation, ladite région dopée du second type étant connectée à une source de potentiel de référence, et ladite région dopée du premier type s'étendant jusqu'à une région dopée du second type appartenant à la structure de récupération des charges ;
- l'ensemble de récupération de charges comprend une pluralité de secondes régions dopées du second type enterrées dans le substrat formant chacune une diode enterrée avec ledit substrat, apte à capter dans le substrat au moins une partie des charges injectées par une diode d'injection commune, et à accumuler ces charges pendant un cycle d'intégration de charges ;
- la diode d'injection est formée d'une pluralité de premières régions dopées du second type électriquement liées entre elles ;
- la seconde région dopée de la diode de collecte enterrée est configurée pour être complètement déplétée à l'issue du transfert de charge vers la structure de récupération de charges.

L'invention concerne un procédé de fonctionnement d'une structure de circuit de lecture selon la revendication 13.

L'invention concerne également un circuit de lecture matriciel comprenant une pluralité de structures de circuit de lecture selon l'invention.

L'invention concerne également un capteur hybride comprenant un premier substrat sur lequel est formé un circuit de lecture selon l'invention, et un second substrat sur lequel est formée une matrice d'éléments sensibles à un rayonnement électromagnétique constituant les sources de charges extérieures, des photodiodes. Le circuit de lecture et la matrice d'éléments sensibles peuvent être reliés par une liaison dans une configuration selon la technique de puce retournée.

PRESENTATION DES FIGURES

L'invention sera mieux comprise, grâce à la description ci-après, qui se rapporte à des modes de réalisations et des variantes selon la présente invention, donnés à titre d'exemples non limitatifs et expliqués avec référence aux dessins schématiques annexés, dans lesquels :

- les figures 1a et 1b, déjà commentées, illustrent des exemples de configurations possibles de capteur hybride, selon la technique de puce retournée ;
- les figures 2a, 2b et 2c, déjà commentées, illustrent des exemples de circuit de lecture de la photodiode dans une technologie CMOS, appartenant à l'état de la technique ;
- la figure 3 illustre schématiquement une structure de circuit de lecture selon un mode de réalisation possible de l'invention ;
- la figure 4 illustre schématiquement le cycle de fonctionnement de la structure de la figure 3 ;
- les figures 5 à 9 illustrent schématiquement une structure de circuit de lecture selon des modes de réalisation possibles de l'invention.

Dans les figures, les éléments similaires sont désignés par les mêmes références numériques.

DESCRIPTION DETAILLEE

La description qui va suivre est dans un premier temps faite en référence à une structure de circuit de lecture constituée sur un substrat semi-conducteur de type P. Cependant, l'invention n'est pas limitée à ce mode de réalisation qui ne revêt qu'un caractère illustratif.

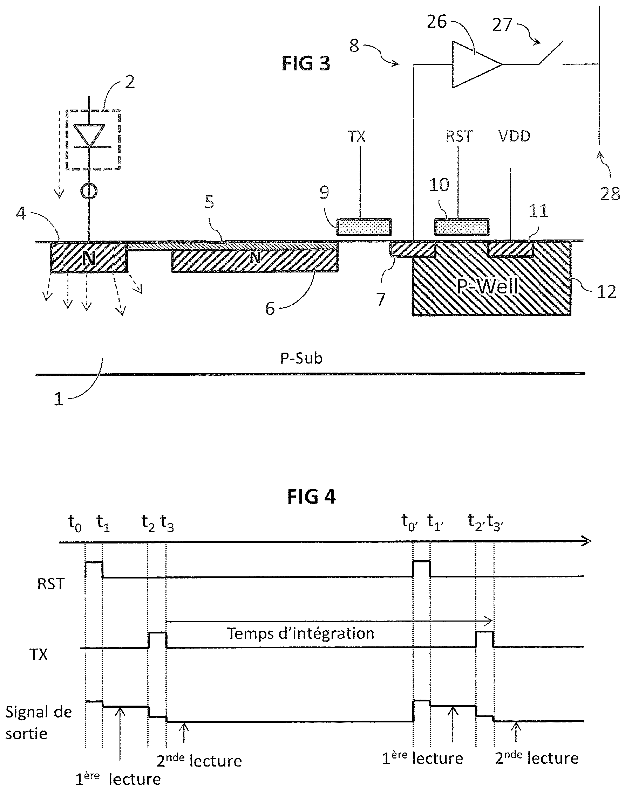

En référence à la figure 3, la structure de circuit de lecture est réalisée sur un substrat 1 semi-conducteur de type P (P-sub). Le substrat 1 présente différentes régions dopées constituant des éléments de la structure de circuit de lecture. La structure de circuit de lecture actif est destinée à mesurer les charges reçues d'une source de charges 2 extérieure au substrat 1. Cette source de charges 2 est une photodiode réalisée sur un second substrat différent du substrat 1 sur lequel est réalisée la structure de circuit de lecture. Notamment, cette source de charges 2 extérieure peut être réalisée sur un second substrat comme dans les configurations hybrides du type de celles illustrées par les figures 1a et 1b. La source de charges 2 extérieure pourrait également être une source de courant d'un autre type qu'une photodiode.

Une jonction PN est constituée dans une première région dopée 4 du substrat 1 pour recevoir des charges électriques de la source de charges 2 extérieure au substrat 1. La première région dopée 4 du substrat est dopée N. La source de charges 2 est connectée à la jonction PN d'injection 4, par exemple via un contact d'hybridation 3 formé par une liaison de type soudure, comme dans les exemples des figures 1a et 1b. La jonction PN reçoit donc le courant électrique généré par la source de charges 2 extérieure au substrat 1.

La première jonction PN est polarisée en direct de manière à pouvoir injecter dans le substrat 1 les charges reçues de la source de charges 2 extérieure au substrat 1. La première jonction PN constitue ainsi une diode d'injection de charges dans le substrat 1. L'injection des charges dans le substrat 1 par la diode d'injection est représentée par des flèches en tirets sur la figure 3. Par la suite, il n'y aura pas de distinction faite entre la diode et la région dopée qui constitue avec le substrat une jonction PN.

Dans le cas d'un substrat 1 de type P et d'une première région dopée 4 de type N, les charges injectées sont des électrons, et le nombre d'électrons libres ainsi injectés dans le substrat 1 est proportionnel au produit entre la durée d'injection et le courant électrique circulant entre la photodiode 2 et la première région dopée 4.

La structure de circuit de lecture comprend une seconde jonction PN comprenant une seconde région dopée 6 du second type, enterrée dans le substrat, et formant avec celui-ci une diode de collecte enterrée, apte à collecter dans le substrat 1 au moins une partie des charges injectées par la diode d'injection et à accumuler ces charges pendant un cycle d'intégration de charges.

La distance entre la seconde région dopée 6 et la première région dopée 4 est inférieure à la longueur de diffusion des électrons dans le substrat 1 à une température nominale d'utilisation, par exemple à 20°C, et est de préférence inférieure à 150 $\mu$m. Il n'y a pas de transistor entre la première région dopée 4 et la seconde région dopée 6 : elles sont séparées par du substrat 1. Les charges sont injectées dans le substrat 1 au niveau de la première région dopée 4 et diffusent dans ledit substrat 1. Les charges sont alors collectées par la seconde région dopée 6. Les charges injectées passent par la profondeur du substrat 1 pour être collectées par la seconde région dopée.

La jonction PN formée autour de cette seconde région dopée 6 enterrée et la profondeur de pénétration de la zone de déplétion dans celle-ci dépend du dopage et de la tension de polarisation de la seconde région dopée 6. Quand la zone de déplétion envahit toute cette seconde région dopée 6, il n'y a plus de charges mobiles, c'est-à-dire plus d'électrons libres dans le cas d'une seconde région dopée 6 de type N. La seule charge restante dans cette seconde région dopée 6 est alors la charge fixe, positive dans le cas d'un second type N, laissée par les atomes dopants.

La seconde région dopée 6 est enterrée dans le substrat 1 de sorte que la zone de charge d'espace (également appelée zone de déplétion) de la jonction entre ladite seconde région dopée 6 et le substrat 1 n'atteint pas la surface du substrat 1 quand ladite région dopée 6 est dépourvue de charges mobiles.

A cet égard, une zone surfacique de dopage 5 du premier type, en l'occurrence P, peut être prévue entre la région dopée 6 de la diode de collecte enterrée et la surface du substrat 1, afin d'empêcher la zone de déplétion d'atteindre cette surface.

L'article "Estimâtes for Scaling of Pinned Photodiodes" de Alex Krymski et al., 2005 IEEE Workshop on Charge-Coupled Devices and Advanced Image Sensors donne de plus amples détails sur ce point.

Une fois exempt de charges libres, le potentiel de la seconde région dopée 6 ne varie plus, mais peut toujours attirer des porteurs de charges mobiles, en l'occurrence des électrons dans le cas d'une seconde région dopée N. Ainsi, si des porteurs de charges libres sont générés ou injectés à proximité de cette seconde région dopée 6, ils peuvent y être attirés et fixés. La seconde région dopée 6 peut alors jouer le rôle d'un intégrateur sans charge résiduelle initiale. A l'état initial après le transfert de charges, le potentiel auquel est soumise la seconde région dopée 6 est maximal, et décroît au fur et à mesure de la collecte des charges injectées par la diode d'injection.

Par conséquent, la seconde région dopée 6 du second type composant la diode de collecte enterrée est configurée (via son positionnement, ses dimensions et les concentrations de dopants) pour être complètement déplétée à l'issue du transfert de charge vers la structure de récupération de charges. Il est à noter en outre que l'aspect complètement déplété de la seconde région dopée 6 de la diode de collecte enterrée permet de supprimer le bruit KTC.

La structure de circuit de lecture comprend également une structure de récupération de charges configurée pour récupérer les charges accumulées dans ladite diode de collecte.

A l'instar de l'exemple illustré par la figure 3, cette structure de récupération peut comprendre un nœud de diffusion flottant 7 formé par une région dopée du type N dans le substrat 1, connectée à un dispositif de sortie 8, ladite région dopée de type N présentant une concentration en dopants supérieure à celle de la seconde région dopée 6 de type N formant avec le substrat 1 la diode de collecte enterrée.

La structure de récupération de charges comprend également un transistor de transfert de type MOS dont la grille de transfert 9 est située entre ladite diode de collecte enterrée et ledit nœud de diffusion flottant 7. La grille 9 est au-dessus et électriquement isolée du substrat 1 et peut être commandée par un signal de transfert TX pour transférer les charges qui sont accumulées dans la seconde région dopée 6 de la diode enterrée vers la structure de récupération de charges, ici le nœud de diffusion flottant 7.

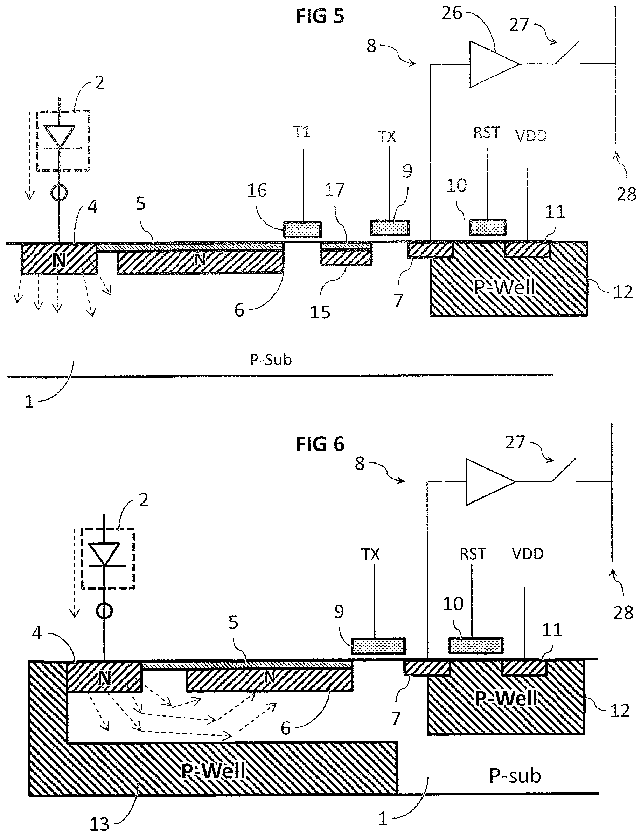

Ainsi qu'illustré par la figure 5, la structure de récupération des charges peut également comprendre une mémoire constituée par une région dopée 15 du second type, i.e. N, formée dans le substrat 1 entre la diode de collecte enterrée et le nœud de diffusion flottant 7 connecté au dispositif de sortie 8. Cette région dopée 15 est enterrée comme la seconde région dopée 6, et à cet effet une zone surfacique de dopage du premier type, i.e. P, isole ladite région dopée 15 de la surface du substrat 1. Une grille 16 de transistor commandée par un signal T1 peut commander le transfert des charges depuis la diode de collecte enterrée vers la mémoire, tandis que la grille 9 du transistor de transfert sert à commander le transfert des charges depuis la mémoire vers le nœud de diffusion flottant 7. Il est à noter que la mémoire présente une concentration en dopant de type N supérieure à celle de la seconde région dopée 6, mais inférieure à celle du nœud de diffusion flottant 7, afin de présenter un gradient de potentiel propre à permettre le transfert des charges. Plusieurs mémoires peuvent être disposées de façon similaire entre la diode de collecte enterrée et le nœud de diffusion flottant 7 connecté au dispositif de sortie 8.

Le dispositif de sortie 8, par lequel peut transiter le signal de sortie résultant de la lecture de la tension au niveau de la structure de récupération de charges, peut comprendre un amplificateur 26 et un commutateur de sélection 27 relié à l'amplificateur 26, ledit commutateur de sélection 27 pouvant être sélectivement commandé pour relier la sortie de l'amplificateur 26 à un bus de multiplexage 28.

La structure de circuit de lecture comprend également des moyens pour initialiser la structure de récupération de charges avant le transfert de charges, en ramenant le potentiel électrique de ladite structure de récupération de charges à un potentiel initial supérieur au potentiel auquel la seconde région dopée 6 est complètement déplétée (appelé "pinning voltage" en anglais), de sorte que lorsque la grille 9 du transistor de transfert autorise le transfert des charges accumulées dans la seconde région dopée 6 de la diode enterrée.

A l'instar de l'exemple illustré par la figure 3, les moyens pour initialiser la structure de récupération de charges peuvent comprendre un transistor d'initialisation dont la grille 10 est située entre le nœud de diffusion flottant 7 et une source de potentiel de référence VDD. La grille 10 est électriquement isolée du substrat et peut être commandée pour amener le potentiel dudit nœud de diffusion flottant 7 audit potentiel initial.

La structure peut comprendre une région dopée 12 du premier type formée dans le substrat 1 (P-Well) qui entoure une région dopée du second type 11 des moyens d'initialisation de la structure de récupération de charges. Cette région dopée 11 du second type est connectée à une source de potentiel de référence VDD, et ladite région 12 du premier type s'étend jusqu'à une région dopée du second type 7 appartenant à la structure de récupération des charges, typiquement le nœud de diffusion flottant 7.

La figure 4 illustre le fonctionnement de la structure de circuit de lecture dans le cas où le premier type est le type P, et où le second type est le type N, comme dans l'exemple de la figure 3. Au temps $t_0$, qui correspond à la fin du cycle d'intégration précédent, la structure de récupération de charges, c'est-à-dire le nœud de diffusion flottant 7, est initialisée au moyen du signal d'initialisation RST à l'état haut appliqué à la grille du transistor d'initialisation 10. Le transistor d'initialisation devient passant et le nœud de diffusion flottant 7 est alors connecté à la source de potentiel de référence VDD, l'amenant ainsi à un potentiel initial. Ce potentiel initial présente un niveau suffisant pour pouvoir opérer un transfert total des charges collectées par la diode de collecte enterrée 6 lorsqu'un canal électrique relie la diode de collecte à la structure de récupération des charges.

Ensuite, à l'instant $t_1$, le signal d'initialisation RST appliqué à la grille du transistor d'initialisation 10 est ramené à un niveau bas, de sorte que le transistor d'initialisation redevienne bloquant.

A l'instant $t_2$, le signal de transfert TX appliqué à la grille du transistor de transfert 9 est amené à un niveau haut, de sorte à autoriser le transfert des charges accumulées dans la seconde région dopée 6 de la diode enterrée vers la structure de récupération de charges constituée par le nœud de diffusion flottant 7, par l'établissement d'un canal électrique dans le substrat sous-jacent à la grille du transistor de transfert 9.

Les charges collectées dans la seconde région dopée 6 de la diode de collecte sont alors transférées vers le nœud de diffusion flottant 7 en totalité, de sorte que la seconde région dopée 6 est complètement déplétée à l'issue de ce transfert. Comme indiqué plus haut, la zone de déplétion de la jonction PN de la diode enterrée recouvre complètement la seconde région dopée 6. Le potentiel au niveau de celle-ci correspond alors au potentiel dit "pinning voltage", qui dépend de la configuration des dopants.

A l'instant $t_3$, le signal de transfert TX appliqué à la grille du transistor de transfert 9 est amené à un niveau bas de sorte à rendre bloquant le transistor de transfert. Un nouveau cycle peut alors commencer, dont les instants $t_0$', $t_1$', $t_2$' et $t_3$' correspondent respectivement aux instants $t_0$, $t_1$, $t_2$ et $t_3$.

Une première lecture du signal via le dispositif de sortie 8 est faite entre les instants $t_1$ et $t_2$, et une seconde lecture est faite après $t_3$. La première lecture renseigne sur le niveau de reset, c'est-à-dire le niveau initial de potentiel atteint par la structure de récupération de charges après son initialisation. Le temps d'intégration, c'est-à-dire de collecte des charges injectées par la diode de collecte enterrée 6, correspond à l'intervalle entre les instants $t_3$ et $t_3$'. La différence de tension entre la première lecture et la seconde lecture donne le signal d'image recherché.

Il est à noter que les intervalles entre les instants $t_0$ et $t_1$, ainsi qu'entre les instants $t_2$ à $t_3$, sont très courts, de l'ordre de quelques nanosecondes à quelques microsecondes au maximum, tandis que le temps d'intégration est de l'ordre de quelques millisecondes. On constate donc que l'opération de transfert de charges permet des doubles lectures corrélées très rapprochées dans le temps, puisque la première lecture et la seconde lecture interviennent respectivement avant et après le transfert des charges, et ne sont pas séparées par le temps d'intégration comme dans les configurations de l'état de la technique précédemment exposées. L'influence du bruit 1/f est donc réduite par rapport à ces configurations.

La figure 6 présente une structure de circuit de lecture similaire à celle de la figure 3, avec cependant la présence d'une zone de confinement 13 formée par une région dopée du premier type formée dans le substrat 1, ladite zone de confinement 13 s'étendant dans la profondeur du substrat 1 au moins en regard de la première région dopée 4 de la diode d'injection. Comme illustré, la zone de confinement 13 peut en outre s'étendre en direction de la surface du substrat 1 jusqu'à la périphérie de la diode d'injection.

Cette zone de confinement 13 permet de confiner les charges injectées par la diode d'injection dans une région du substrat 1 dans laquelle ces charges sont susceptibles d'être attirées par la diode enterrée. Dans le cas illustré par la figure 4, cette zone de confinement 13 correspond à un caisson P (« P-Well » en anglais) profond qui laisse cependant libre une région du substrat 1 entre la diode d'injection et la diode enterrée.

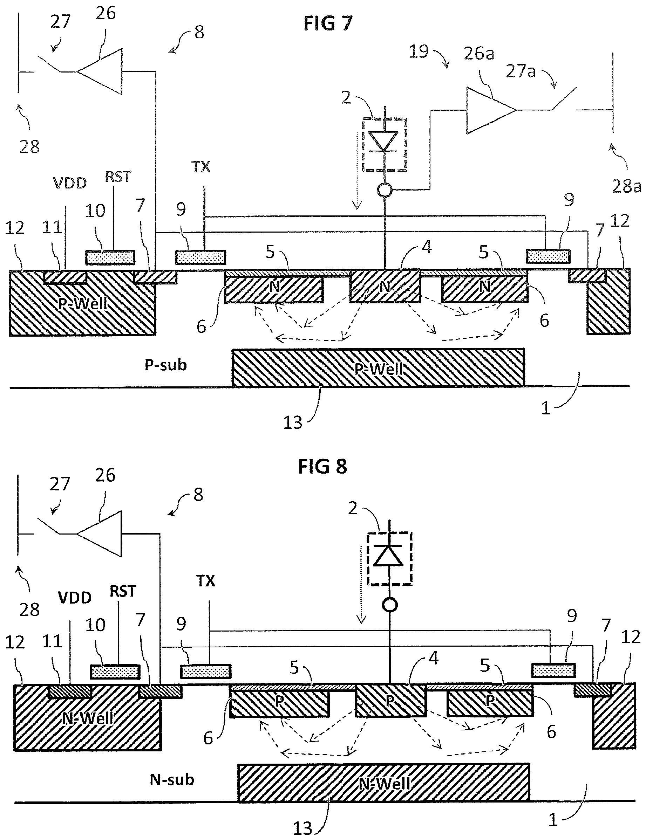

La figure 7 présente une autre configuration, dans laquelle l'ensemble de récupération 5 de charges comprend une pluralité de secondes régions dopées 6 du second type enterrées dans le substrat 1 formant chacune une diode enterrée avec ledit substrat, apte à capter dans le substrat au moins une partie des charges injectées par la diode commune d'injection, et à accumuler ces charges pendant un cycle d'intégration de charges. Ces diodes enterrées 6 dans le substrat 1 se répartissent autour de la diode d'injection 4, dans différentes directions par rapport à ladite diode d'injection.

Ainsi, dans la mesure où les charges injectées par la diode d'injection 4 peuvent être collectées dans les différentes directions où sont disposées ces diodes enterrées 6, il y a moins de pertes, et la collecte des charges injectées s'en trouve améliorée.

Afin d'améliorer encore l'injection et la collecte des charges dans le substrat 1, la diode d'injection 4 peut être formée d'une pluralité de premières régions dopées du second type électriquement liées entre elles. De préférence, chacune de ces premières régions dopées étant situées à proximité d'au moins une diode de collecte enterrée 6, c'est-à-dire à une distance inférieure à la longueur de diffusion des électrons dans le substrat 1 à une température nominale d'utilisation, par exemple à 20°C, et de préférence inférieure à 150 μm, voire 100 μm.

Comme visible sur la figure 7, l'ensemble de récupération de charges comprend alors une pluralité de structures de récupération de charges, par exemple des noeuds de diffusion flottants 7, chacun associé à une diode enterrée 6, et connectés ensemble à un même bus 8 pour délivrer le signal de sortie. Pour chaque association entre une structure de récupération de charges et une diode enterrée 6, un transistor de transfert permet de commander le transfert des charges depuis la diode enterrée vers la structure de récupération de charges. Les grilles 10 des transistors de transfert sont commandées par le même signal de transfert TX.

La figure 8 présente une autre possibilité pour la structure de circuit de lecture, qui reprend la configuration de la figure 7, dans laquelle le premier type est le type N et le second type est le type P. Il est à noter que la même modification peut être opérée pour les configurations exposées en référence aux figures 3, 5 et 6. En conséquence, le substrat 1 est ici du type N, la première région dopée 4 formant avec le substrat la diode d'injection est de type P, la seconde région dopée 6 formant avec le substrat la diode enterrée est de type P, la structure de récupération présente une région dopée P formant le nœud de diffusion flottant 7, et la zone de confinement 13 est du type N.

Dans ce cas, les porteurs de charge injectés par la photodiode 2 extérieure au substrat 1 sont des trous, qui sont ensuite collectés par la diode enterrée puis récupérés par la structure de récupération.

Dans cette figure 7, une caractéristique supplémentaire est indiquée, par laquelle un second dispositif de sortie 19 est branché sur la branche d'injection des charges entre la source de charge extérieure 2 et la diode d'injection 4. Ce second dispositif de sortie 19 comprend un amplificateur 26a relié par un commutateur de sélection 27a à un bus de multiplexage 28a, qui peut être distinct ou confondu avec le bus de multiplexage auquel est relié le dispositif de sortie 8. L'impédance d'entrée de l'amplificateur 26a est très grande, idéalement infinie, équivalente à celle d'une grille de transistor MOS.

Ce second dispositif de sortie 19 permet une lecture de la tension aux bornes de la diode d'injection et permet ainsi d'obtenir une lecture logarithmique du courant généré par la source de charges extérieure 2 et injecté dans le substrat 1, via la relation exponentielle entre la tension et le courant passant de la source de charge extérieure 2 à la diode d'injection. On obtient alors la possibilité d'un double mode de lecture : linéaire et logarithmique, ce qui améliore la dynamique de la structure de circuit de lecture puisque celle-ci peut répondre à la fois aux faibles et aux fortes expositions lumineuses.

Cependant, les tranches (« wafers » en anglais) de type P sont plus populaires en fonderie CMOS.

Afin de pouvoir réaliser un circuit de lecture de pixel selon la configuration dans laquelle le premier type est le type N et le second type est le type P, il est possible de prévoir la réalisation de la structure de circuit de lecture dans un caisson de type N faiblement dopé (« LDN-Well » en anglais pour « lightly-doped N-type well »).

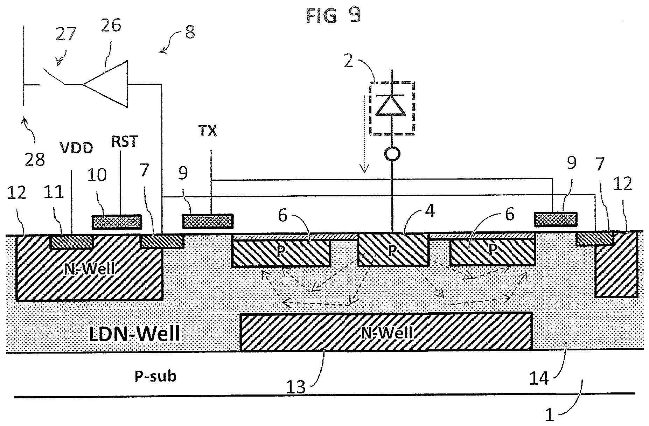

La figure 9 présente un tel exemple, avec un caisson 14 de type N faiblement dopé formé dans le substrat 1 de type P, dans lequel sont formés l'ensemble des régions dopées évoquées précédemment.

L'invention n'est pas limitée au mode de réalisation décrit et représenté aux figures annexées. Des modifications restent possibles, notamment du point de vue de la constitution des divers éléments ou par substitution d'équivalents techniques, sans sortir pour autant du domaine de protection de l'invention.

## Revendications

1. Structure de circuit de lecture, constituée sur un substrat semi-conducteur (1) d'un premier type, et destinée à mesurer les charges reçues d'une photodiode (2) extérieure au substrat (1) selon des cycles successifs d'intégration de charges, ladite structure comprenant :

   • une diode d'injection formée dans le substrat (1) par une première jonction PN polarisée en direct comprenant une première région dopée (4) d'un second type du substrat (1) pour recevoir des charges électriques de ladite photodiode extérieure (2), et polarisée en direct pour injecter dans le substrat (1) les charges reçues de la photodiode extérieure (2),

   • une diode de collecte formée dans le substrat (1) par une seconde jonction PN comprenant une seconde région dopée (6) du second type enterrée dans le substrat (1) et apte à collecter dans le substrat (1) au moins une partie des charges injectées par la diode d'injection et à accumuler ces charges pendant un cycle d'intégration,

   • une structure de récupération de charges (7, 15), configurée pour récupérer les charges accumulées dans ladite diode de collecte,

   • des moyens pour initialiser la structure de récupération de charges (7,15) à la fin de chaque cycle d'intégration, en ramenant le potentiel électrique de ladite structure de récupération de charges à un potentiel initial,

   • dans lequel il n'y a pas de transistor relié entre la première région dopée (4) et la seconde région dopée (6), la première région (4) et la seconde région étant séparée par du substrat (1).

2. Structure de circuit de lecture selon la revendication 1, dans lequel la structure de récupération de charges (7) comprend un nœud de diffusion flottant (7) formé par une région dopée du second type dans le substrat (1), connectée à un dispositif de sortie (8).

3. Structure de circuit de lecture selon la revendication précédente, dans laquelle les moyens pour initialiser la structure de récupération de charges comprennent un transistor d'initialisation (10) dont la grille, électriquement isolée du substrat (1), est située entre ledit nœud de diffusion (7) et une source de potentiel de référence (VDD), et est adaptée pour être commandée pour amener le potentiel dudit nœud de diffusion (7) audit potentiel initial.

4. Structure de circuit de lecture selon l'une des revendications 2 ou 3, comprenant un transistor de transfert de type MOS dont la grille de transfert (9) est située entre ladite diode enterrée et ledit nœud de diffusion flottant (7), au-dessus et électriquement isolée du substrat (1), et qui est commandable pour transférer les charges collectées dans la seconde région dopée (6) vers le nœud de diffusion flottant (7).

5. Structure de circuit de lecture selon l'une quelconque des revendications précédentes, dans lequel la structure de récupération de charges comprend

   • une mémoire constituée par une région dopée (15) du second type et
   • un nœud de diffusion flottant (7) formé par une région dopée du second type connectée à un dispositif de sortie (8),

   ladite mémoire étant formée dans le substrat (1) entre la diode enterrée et le nœud de diffusion flottant (7).

6. Structure de circuit de lecture selon l'une quelconque des revendications précédentes, dans laquelle un dispositif de sortie (19) est branché entre la photodiode extérieure (2) et la diode d'injection afin de permettre une lecture de la tension aux bornes de la diode d'injection et obtenir ainsi une lecture logarithmique du courant passant entre la photodiode extérieure (2) et la diode d'injection.

7. Structure de circuit de lecture selon l'une quelconque des revendications précédentes, comprenant une zone de confinement (13) formée par une région dopée du premier type formée dans le substrat (1), ladite zone de confinement (13) s'étendant dans la profondeur du substrat (1) au moins en regard de la première région dopée (4) composant la diode d'injection.

8. Structure de circuit de lecture selon la revendication précédente, dans lequel la zone de confinement (13) s'étend en outre en direction de la surface du substrat (1) jusqu'à la périphérie de la diode d'injection.

9. Structure de circuit de lecture selon l'une quelconque des revendications précédentes, comprenant une région dopée du premier type (12) formée dans le substrat (1) qui entoure une région dopée du second type (11) des moyens d'initialisation, ladite région dopée du second type (11) étant connectée à une source de potentiel de référence, et ladite région dopée du premier type s'étendant jusqu'à une région dopée du second type appartenant à la structure de récupération des charges (7).

10. Structure de circuit de lecture selon l'une quelconque des revendications précédentes, dans lequel l'ensemble de récupération de charges comprend une pluralité de secondes régions dopées (6) du second type enterrées dans le substrat (1) formant chacune une diode enterrée avec ledit substrat (1), apte à capter dans le substrat au moins une partie des charges injectées par une diode d'injection commune (4), et à accumuler ces charges pendant un cycle d'intégration de charges.

11. Structure de circuit de lecture selon la revendication précédente, dans laquelle la diode d'injection est formée d'une pluralité de premières régions dopées du second type électriquement liées entre elles.

12. Structure de circuit de lecture selon l'une quelconque des revendications précédentes, dans laquelle la seconde région dopée (6) de la diode de collecte enterrée est configurée pour être complètement déplétée à l'issue du transfert de charge vers la structure de récupération de charges (7).

13. Procédé de fonctionnement d'une structure de circuit de lecture selon l'une quelconque des revendications précédentes, dans lequel

   - une première lecture de la tension au niveau de la structure de récupération de charges est effectuée après l'initialisation de ladite structure de récupération de charges et avant le transfert des charges depuis la diode enterrée vers ladite structure de récupération de charges, et
   - une seconde lecture de la tension au niveau de la structure de récupération de charges est effectuée après le transfert des charges depuis la diode enterrée vers ladite structure de récupération de charges,

   le signal d'image correspondant à la différence entre la première lecture et la seconde lecture.

14. Circuit de lecture matriciel comprenant une pluralité de structures de circuit de lecture selon l'une des revendications 1 à 12.

15. Capteur hybride comprenant un premier substrat sur lequel est formé un circuit de lecture selon la revendication précédente, et un second substrat sur lequel est formée une matrice d'éléments sensibles à un rayonnement électromagnétique constituant les photodiodes extérieures (2).

**Patentansprüche**

1. Ausleseschaltungsstruktur, die auf einem Halbleitersubstrat (1) eines ersten Typs besteht und dazu bestimmt ist, die von einer Photodiode (2) außerhalb des Substrats (1) gemäß aufeinanderfolgenden Ladungsintegrationszyklen empfangenen Ladungen zu messen, wobei die Struktur umfasst:

   • an eine Injektionsdiode, die im Substrat (1) von einem ersten direkt polarisierten PN-Übergang gebildet wird, umfassend eine erste dotierte Region (4) eines zweiten Typs des Substrats (1), um elektrische Ladungen von der äußeren Photodiode (2) zu empfangen, und direkt polarisiert, um die von der äußeren Photodiode (2) empfangenen Ladungen in das Substrat (1) zu injizieren,
   • eine Sammeldiode, die im Substrat (1) von einem zweiten PN-Übergang gebildet wird, umfassend eine zweite dotierte Region (6) des zweiten Typs, die im Substrat (1) vergraben und dazu in der Lage ist, im Substrat (1) mindestens einen Teil der von der Injektionselektrode injizierten Ladungen zu sammeln und diese Ladungen während eines Integrationszyklus zu akkumulieren,
   • eine Ladungsrückgewinnungsstruktur (7, 15), die dafür konfiguriert ist, die in der Sammeldiode akkumulierten Ladungen rückzugewinnen,
   • Mittel, um die Ladungsrückgewinnungsstruktur (7, 15) am Ende jedes Integrationszyklus unter Zurücksetzen des elektrischen Potentials der Ladungsrückgewinnungsstruktur auf ein ursprüngliches Potential zu initialisieren,
   • wobei zwischen der ersten dotierten Region (4) und der zweiten dotierten Region (6) kein Transistor angeschlossen ist, wobei die erste Region (4) und die zweite Region durch Substrat (1) getrennt sind.

2. Ausleseschaltungsstruktur nach Anspruch 1, wobei die Ladungsrückgewinnungsstruktur (7) einen schwebenden Diffusionsknoten (7) umfasst, der von einer dotierten Region des zweiten Typs im Substrat (1) gebildet wird, die mit einer Ausgangsvorrichtung (8) verbunden ist.

3. Ausleseschaltungsstruktur nach dem vorstehenden Anspruch, wobei die Mittel, um die Ladungsrückgewinnungsstruktur zu initialisieren, einen Initialisierungstransistor (10) umfassen, dessen Gatter elektrisch vom Substrat (1) isoliert zwischen dem Diffusionsknoten (7) und einer Referenzpotentialquelle (VDD) liegt und dafür geeignet ist, angesteuert zu werden, um das Potential des Diffusionsknotens (7) auf das ursprüngliche Potential zu setzen.

4. Ausleseschaltungsstruktur nach einem der Ansprüche 2 oder 3, umfassend einen Übertragungstransistor vom MOS-Typ, dessen Übertragungsgatter (9) zwischen der vergrabenen Diode und dem schwebenden Diffusionsknoten (7) liegt, oberhalb des Substrats (1) und elektrisch von demselben isoliert, und das angesteuert werden kann, um die in der zweiten dotierten Region (6) gesammelten Ladungen zum schwebenden Diffusionsknoten (7) zu übertragen.

5. Ausleseschaltungsstruktur nach einem der vorstehenden Ansprüche, wobei die Ladungsrückgewinnungsstruktur umfasst

   • einen Speicher, der aus einer dotierten Region (15) des zweiten Typs besteht, und
   • einen schwebenden Diffusionsknoten (7), der von einer dotierten Region des zweiten Typs gebildet wird, welche mit einer Ausgangsvorrichtung (8) verbunden ist,

   wobei der Speicher im Substrat (1) zwischen der vergrabenen Elektrode und dem schwebenden Diffusionsknoten (7) gebildet ist.

6. Ausleseschaltungsstruktur nach einem der vorstehenden Ansprüche, wobei zwischen die äußere Photodiode (2) und die Injektionsdiode eine Ausgangsvorrichtung (19) geschaltet ist, um ein Auslesen der Spannung an den Klemmen der Injektionsdiode zu ermöglichen und so eine logarithmische Auslesung des Stroms zu erhalten, der zwischen der äußeren Photodiode (2) und der Injektionsdiode fließt.

7. Ausleseschaltungsstruktur nach einem der vorstehenden Ansprüche, umfassend eine Confinement-Zone (13), die von einer dotierten Region des ersten Typs gebildet wird, welche im Substrat (1) gebildet ist, wobei sich die Confinement-Zone (13) mindestens der ersten dotierten Region (4), aus welcher die Injektionsdiode besteht, zugewandt in die Tiefe des Substrats (1) erstreckt.

8. Ausleseschaltungsstruktur nach dem vorstehenden Anspruch, wobei sich die Confinement-Zone (13) weiter bis zum Umfang der Injektionsdiode in Richtung der Oberfläche des Substrats (1) erstreckt.

9. Ausleseschaltungsstruktur nach einem der vorstehenden Ansprüche, umfassend eine im Substrat (1) gebildete dotierte Region des ersten Typs (12), die eine dotierte Region des zweiten Typs (11) der Initialisierungsmittel umgibt, wobei die dotierte Region des zweiten Typs (11) mit einer Referenzpotentialquelle verbunden ist, und wobei sich die dotierte Region des ersten Typs bis zu einer dotierten Region des zweiten Typs erstreckt, die zur Ladungsrückgewinnungsstruktur (7) gehört.

10. Ausleseschaltungsstruktur nach einem der vorstehenden Ansprüche, wobei die Ladungsrückgewinnungsanordnung eine Vielzahl von im Substrat (1) vergrabenen zweiten dotierten Regionen (6) des zweiten Typs umfasst, die jede zusammen mit dem Substrat (1) eine vergrabene Diode bilden, welche in der Lage ist, im Substrat mindestens einen Teil der Ladungen zu fangen, die von einer gemeinsamen Injektionsdiode (4) injiziert werden, und diese Ladungen während eines Ladungsintegrationszyklus zu akkumulieren.

11. Ausleseschaltungsstruktur nach dem vorstehenden Anspruch, wobei die Injektionsdiode von einer Vielzahl erster dotierter Regionen des zweiten Typs gebildet wird, die elektrische miteinander verbunden sind.

12. Ausleseschaltungsstruktur nach einem der vorstehenden Ansprüche, wobei die zweite dotierte Region (6) der vergrabenen Sammeldiode dafür konfiguriert ist, am Ende der Ladungsübertragung zur Ladungsrückgewinnungsstruktur (7) vollständig depletiert zu werden.

13. Betriebsverfahren einer Ausleseschaltungsstruktur nach einem der vorstehenden Ansprüche, wobei

- nach dem Initialisieren der Ladungsrückgewinnungsstruktur und vor dem Übertragen der Ladungen von der vergrabenen Diode zur Ladungsrückgewinnungsstruktur ein erstes Auslesen der Spannung im Bereich der Ladungsrückgewinnungsstruktur vorgenommen wird, und
- nach dem Übertragen der Ladungen von der vergrabenen Diode zur Ladungsrückgewinnungsstruktur ein zweites Auslesen der Spannung im Bereich der Ladungsrückgewinnungsstruktur vorgenommen wird,

wobei das Bildsignal der Differenz zwischen der ersten Auslesung und der zweiten Auslesung entspricht.

14. Matrixförmige Ausleseschaltung, die eine Vielzahl von Ausleseschaltungsstrukturen nach einem der Ansprüche 1 bis 12 umfasst.

15. Hybridsensor, umfassend ein erstes Substrat, auf dem eine Ausleseschaltung nach dem vorstehenden Anspruch gebildet ist, und ein zweites Substrat, auf dem eine Matrix aus für eine elektromagnetische Strahlung empfindlichen Elementen gebildet ist, aus denen die äußeren Photodioden (2) bestehen.

**Claims**

1. Readout circuit structure, formed on a semi-conductor substrate (1) of a first type, and intended to measure the charges received from a photodiode (2) outside the substrate (1) according to successive charge integration cycles, said structure comprising:

   • an injection diode formed in the substrate (1) by a first forward biased PN junction comprising a first doped region (4) of a second type of the substrate (1) for receiving electric charges from said external photodiode (2), and configured for injecting into the substrate (1) the charges received from the external photodiode (2),
   • a collecting diode formed in the substrate (1) by a second PN junction comprising a second doped region (6) of the second type buried in the substrate (1) and able to collect in the substrate (1) at least one portion of the charges injected by the injection diode and of accumulating these charges during an integration cycle,
   • a charge recovery structure (7, 15), configured for recovering the charges accumulated in said collecting diode,
   • means for initializing the charge recovery structure (7, 15) at the end of each integration cycle, by bringing back the electric potential of said charge recovery structure to an initial potential,
   • in which there is no transistor connected between the first doped region (4) and the second doped region (6), the first region (4) and the second region being separated by the substrate (1).

2. Readout circuit structure according to claim 1, wherein the charge recovery structure (7) comprises a floating diffusion node (7) formed by a doped region of the second type in the substrate (1), connected to an output device (8).

3. Readout circuit structure according to the preceding claim, wherein the means for initializing the charge recovery structure comprise an initialization transistor (10), the gate of which, electrically insulated from the substrate (1), is located between said diffusion node (7) and a reference potential (VDD) source, and is adapted so as to be controlled for bringing the potential of said diffusion node (7) to said initial potential.

4. Readout circuit structure according to one of claims 2 or 3, comprising a transfer transistor of the MOS type, the transfer gate (9) of which is located between said buried diode and said floating diffusion node (7), above and electrically insulated from the substrate (1), and which may be controlled for transferring the charges collected in the second doped region (6) towards the floating diffusion node (7).

5. Readout circuit structure according to any one of the preceding claims, wherein the charge recovery structure comprises

    • a memory formed by a doped region (15) of the second type and
    • a floating diffusion node (7) formed by a doped region of the second type connected to an output device (8),

    said memory being formed in the substrate (1) between the buried diode and the floating diffusion node (7).

6. Readout circuit structure according to any one of the preceding claims, wherein an output device (19) is connected between the external photodiode (2) and the injection diode in order to allow readout of the voltage on the terminals of the injection diode and thus obtain a logarithmic readout of the current passing between the external photodiode (2) and the injection diode.

7. Readout circuit structure according to any one of the preceding claims, comprising a confinement area (13) formed by a doped region of the first type formed in the substrate (1), said confinement area (13) extending in the depth of the substrate (1) at least facing the first doped region (4) making up the injection diode.

8. Readout circuit structure according to the preceding claim, wherein the confinement area (13) further extends towards the surface of the substrate (1) as far as the periphery of the injection diode.

9. Readout circuit structure according to any one of the preceding claims, comprising a doped region of the first type (12) formed in the substrate (1) which surrounds a doped region of the second type (11) of the initialization means, said doped region of the second type (11) being connected to a reference potential source, and said doped region of the first type extending as far as a doped region of the second type belonging to the charge recovery structure (7).

10. Readout circuit structure according to any one of the preceding claims, wherein the charge recovery assembly comprises a plurality of second doped regions (6) of the second type buried in the substrate (1) each forming a buried diode with said substrate (1), able to capture in the substrate at least one portion of the charges injected by a common injection diode (4), and of accumulating these charges during a charge integration cycle.

11. Readout circuit structure according to preceding claim, wherein the injection diode is formed with a plurality of first doped regions of the second type electrically linked together.

12. Readout circuit structure according to any one of the preceding claims, wherein the second doped region (6) of the buried collecting diode is configured so as to be completely depleted at the end of the charge transfer towards the charge recovery structure (7).

13. Method for operating a readout circuit structure according to any one of the preceding claims, wherein

    - a first readout of the voltage at the charge recovery structure is carried out after initializing said charge recovery structure and before transferring the charges from the buried diode towards said charge recovery structure, and
    - a second readout of the voltage at the charge recovery structure is carried out after transferring the charges from the buried diode towards said charge recovery structure,

    the image signal corresponding to the difference between the first readout and the second readout.

14. Array readout circuit comprising a plurality of readout circuit structures according to one of claims 1 to 12.

15. Hybrid sensor comprising a first substrate on which is formed a readout circuit according to the preceding claim, and a second substrate on which is formed an array of elements sensitive to electromagnetic radiation forming the external photodiodes (2).

## FIG 1a

33  32

34

31

37 36  35

## FIG 1b

33 39

34

31

36  38

## FIG 2a

24  $V_{RST}$

RST

27

Signal IM

23

$V_{bias}$

+
−

26

25

28

22

21

20

Niveau de reset

Signal IM

Niveau de fin d'intégration

RST

Temps

## FIG 2b

## FIG 2c

**FIG 3**

26  27

8

2

TX      RST    VDD

9       10      11

4       5               28

N       N       P-Well  12

6       7

P-Sub

1

**FIG 4**

$t_0$ $t_1$   $t_2$ $t_3$                    $t_{0'}$ $t_{1'}$   $t_{2'}$ $t_{3'}$

RST

Temps d'intégration

TX

Signal de
sortie

1ère lecture              1ère lecture      2nde lecture

2nde lecture

1ère lecture

**FIG 5**

**FIG 6**

FIG 7

FIG 8

**FIG 9**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070285545 A

**Littérature non-brevet citée dans la description**

- **ALEX KRYMSKI et al.** Estimâtes for Scaling of Pinned Photodiodes. *2005 IEEE Workshop on Charge-Coupled Devices and Advanced Image Sensors,* 2005